# EUROPÄISCHE PATENTSCHRIFT

(11) **EP 2 325 990 B1**
(45) Veröffentlichungstag und Bekanntmachung des Hinweises auf die Patenterteilung: **11.03.2015**
(21) Anmeldenummer: 10170742.0
(22) Anmeldetag: 26.07.2010
(51) Int. Cl.: H02M 7/00

(54) **Modular aufgebaute Stromrichteranordnung**
Modular frequency converter assembly
Agencement de convertisseur de courant monté de manière modulaire

(30) Priorität: 31.10.2009 DE 102009051518
(43) Veröffentlichungstag der Anmeldung: 25.05.2011
(73) Patentinhaber: SEMIKRON Elektronik GmbH & Co. KG, 90431 Nürnberg (DE)
(72) Erfinder: Vanhyfte, Francois, 95360 Montmagny (FR); Allain, Briag, 78360 Montesson (FR)

(56) Entgegenhaltungen:
- EP-A2- 0 735 810
- EP-A2- 2 023 473
- DE-A1- 3 713 054
- DE-U1- 29 917 467

## Beschreibung

Die Erfindung beschreibt eine Stromrichteranordnung, wie sie zum Teil mehrfach parallel angeordnet beispielhaft in Windkraft- oder Photovoltaikanlagen zur Anpassung der dort erzeugten Ströme an ein Versorgungsnetz dient. Windkraftanlagen erzeugen abhängig von der Windgeschwindigkeit zeitlich variierende Ausgangsspannungen mit ebenso variierender Frequenz. In Photovoltaikanlagen wird üblicherweise zeitlich variierende Gleichspannung erzeugt. Zur Einspeisung in ein Versorgungsnetz ist es allerdings meist notwendig eine definierte Wechselspannung konstanter Frequenz zu erzeugen.

Hierfür sind beispielhaft aus der DE 198 32 225 A1 kaskadierte Anordnungen von handelsüblichen Leistungshalbeitermodulen bekannt. Werden derartige kaskadierte Anordnungen zu einer Stromrichteranordnung verbunden ist deren Servicefreundlichkeit, d.h. der schnelle und wenig aufwändige Austausch von defekten Komponenten ein wesentlicher Aspekt der Konstruktion.

Der Erfindung liegt die Aufgabe zugrunde eine modulare Stromrichteranordnung aufgebaut aus einzelnen Stromrichterbaugruppen vorzustellen, die bei der Herstellung einem einfachen Aufbau und im Servicefall einer einfachen und schnellen Reparatur zugänglich sind.

Diese Aufgabe wird erfindungsgemäß gelöst, durch eine Stromrichteranordnung mit den Merkmalen des Anspruchs 1. Bevorzugte Ausführungsformen sind in den abhängigen Ansprüchen beschrieben.

Den Ausgangspunkt der Erfindung bildet eine modular aufgebaute Stromrichteranordnung ausgebildet aus einer Mehrzahl von vorzugsweise identischen Stromrichterbaugruppen, angeordnet in einer üblicherweise als Schaltschrank ausgebildeten Aufnahmeeinrichtung. Diese Stromrichterbaugruppen bilden somit Hauptmodule der Stromrichteranordnung, die ihrerseits wiederum aus Submodulen, einem Kondensator- und einem Schaltmodul aufgebaut sind. Zur schaltungsgerechten elektrischen Verbindung der Haupt- bzw. Submodule weist die Aufnahmeeinrichtung eine Verbindungseinrichtung auf, die vorzugsweise eine Gleichspannungsverbindungsseinrichtung mit zwei Polaritäten und eine Wechselspannungsverbindungseinrichtung mit mindestens einer, meist drei, Phasen ausgebildet ist.

Das Kondensatormodul weist jeweils eine Mehrzahl von Kondensatoren, sowie mindestens eine Gleichspannungskontakteinrichtung zur elektrischen Verbindung mit einer Gleichspannungskontakteinrichtung des zugeordneten Schaltmoduls und vorzugsweise auch mit der Gleichspannungsverbindungsseinrichtung der Aufnahmeeinrichtung auf. Es kann bevorzugt sein, dies mittels einer gemeinsamen oder zweier räumlich getrennter Gleichspannungskontakteinrichtungen auszubilden.

Das Schaltmodul weist eine Kühleinrichtung, mindestens ein hierauf angeordnetes Leistungshalbleitermodul sowie eine Wechselspannungs- und eine Gleichspannungskontakteinrichtung auf. Die Gleichspannungskontakteinrichtung dient der Verbindung mit der zugeordneten Gleichspannungskontakteinrichtung des Kondensatormoduls wodurch beispielhaft ein Gleichspannungszwischenkreis und eine hiermit verbundene Halbbrückenschaltung ausgebildet werden. Durch die Anordnung dreier Hauptmodule kann somit eine Dreiphasen- Brückenschaltung mit verbundenem Zwischenkreis ausgebildet werden. Hierbei wird im Zwischenkreis temporär Energie gespeichert, in der Brückenschaltung in eine Spannung mir der benötigten Frequenz gewandelt und mittels der Wechselspannungskontakteinrichtungen der jeweiligen Schaltmodule und der Verbindungseinrichtung der Aufnahmeeinrichtung in ein Stromnetz eingespeist.

Erfindungsgemäß weist die Aufnahmeeinrichtung zur mechanischen Anordnung der Haupt- bzw. Submodule ein jeweiliges Schienensystem auf, das vorzugsweise durch zwei U-Profile gebildet wird, die von einer Rückseite zu einer Frontseite der Aufnahmeeinrichtung reichen. Jedes Submodul weist hierzu geeignete Gleitelemente auf, die in dem Schienensystem anordenbar sind und somit von der Frontseite aus eine Montage und Demontage des jeweiligen Submoduls ermöglichen.

Hierbei bilden, von der Rückseite zur Frontseite aus gesehen, die Verbindungseinrichtung der Aufnahmeeinrichtung, das jeweilige Kondensatormodul und das zugeordnet Schaltmodul einen Stapel aus. Bei dieser Anordnung sind auch die schaltungsgerechten elektrischen Verbindungen der jeweiligen Teile des Stapels ausbildbar. Wesentlich ist hierbei, dass die notwendigen Verbindungen, vorzugsweise Schraubverbindungen zur Montage bzw. Demontage des Schaltmoduls wie auch des Hauptmoduls, gebildet aus dem Kondensator- und dem Schaltmodul, von der Frontseite der Aufnahmeeinrichtung aus erreichbar sind. Somit ist diese modular aufgebaute Stromrichteranordnung einerseits einfach herstellbar wie auch ihr Komponenten im Servicefall einfach austauschbar.

Besonders bevorzugte Weiterbildungen der Erfindung sind in der jeweiligen Beschreibung der Ausführungsbeispiele genannt. Die erfinderische Lösung wird zudem an Hand der Ausführungsbeispiele und der Fig. 1 bis 7 weiter erläutert.

Fig. 1 zeigt stark schematisiert den Blick von der Frontseite auf eine erfindungsgemäße Stromrichteranordnung.

Fig. 2 zeigt die eine ebenso stark schematisierte zugehörige Detailansicht

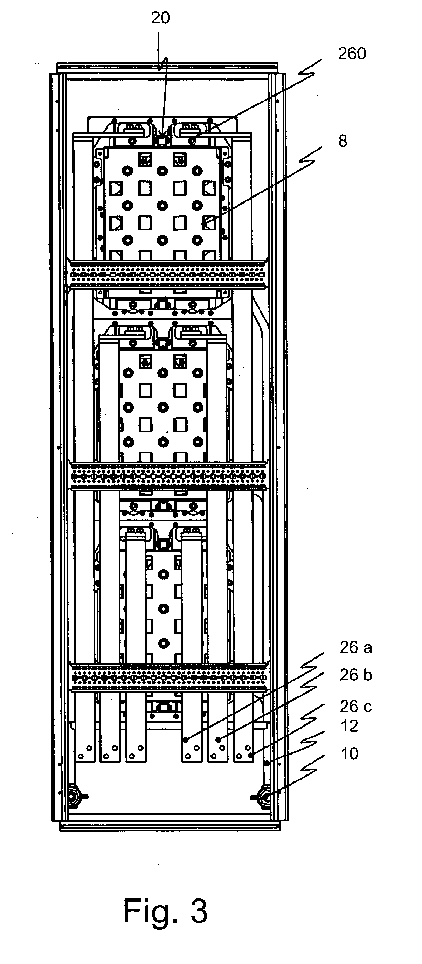

Fig. Fig. 3 bis 7 zeigen detailliertere Ausbildungen einer erfindungsgemäßen Stromrichteranordnung bzw. von deren Komponenten, in verschiedenen Ansichten.

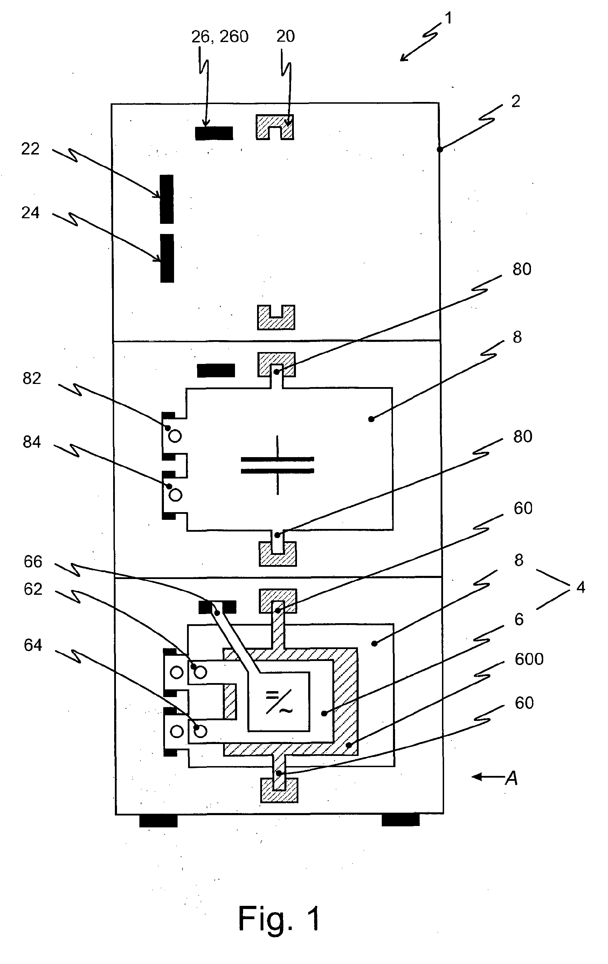

Fig. 1 zeigt stark schematisiert den Blick von der Frontseite auf eine erfindungsgemäße Stromrichteranordnung (1) mit einer als Schaltschrank ausgebildeten Aufnahmeeinrichtung (2) mit drei Aufnahmen für Hauptmodule (4), wobei in der unteren Aufnahme ein Hauptmodul (4), in der mittleren Aufnahme nur ein Kondensatormodul (8) und in der oberen Aufnahme kein Modul angeordnet sind.

Dargestellt ist jeweils das Schienensystem (20), ausgebildet als zwei U-förmigen Führungen, die von der Front- zur Rückseite des Schaltschranks (2) reichen. Ebenso sind hier die Verbindungseinrichtungen (22, 24, 26) des Schaltschranks (2) dargestellt, jeweils die beiden Teile der Gleichspannungsverbindungsseinrichtung (22, 24) für die beiden Polaritäten, sowie eine Wechselspannungsverbindungseinrichtung (26).

In der mittleren Aufnahme ist ein Submodul, das Kondensatormodul (8) angeordnet. Hierzu weist dieses jeweils mindestens ein Gleitelement (80) auf, das in den jeweils zugeordneten U-Profilen des Schienensystems (20) angeordnet ist. Mittels diesen Gleitelements (80) kann das Submodul (8) von der Frontseite aus in dem Schaltschrank (2) montiert, bzw. zur Frontseite hin demontiert werden. Hierzu sind nur die elektrischen und mechanischen Verbindungen zu lösen.

In der unteren Aufnahme ist zusätzlich zum Kondensatormodul (8) auch das Schaltmodul (6) angeordnet. Diese kann bei bereits montiertem Kondensatormodul (8) montiert und auch getrennt von diesem demontiert werden. Hierzu ist auch das Schaltmodul (6) mit Gleitelementen (60) versehen, die in den gleichen Schienensystem (20) wie diejenige des Kondensatormoduls (8) angeordnet sind. Zur notwendigen elektrischen Verbindung sind die jeweiligen Gleichspannungskontakteinrichtungen (22, 24) der beiden Submodule (6, 8) schaltungsgerecht miteinander verbunden. Bei geeigneter Ausbildung dieser Verbindung kann auf eine weitere mechanische Befestigung des Schaltmoduls (6) am Schaltschrank (2) verzichtet werden.

Weiterhin dargestellt ist die Wechselspannungskontakteinrichtung (66) des Schaltmoduls (6), wobei diese mit der Wechselspannungsverbindungseinrichtung (26) mittels eines zusätzlichen parallel zum Schienensystem (20) angeordneten Abschnitt (260) verbunden ist. Dieser zusätzliche Abschnitt (260) schränkt hierbei den Bewegungsraum des Hauptmoduls (4) wie auch der einzelnen Submodule (6, 8) entlang des Schienensystems (20) nicht ein, wodurch die Montage bzw. Demontage nicht behindert wird.

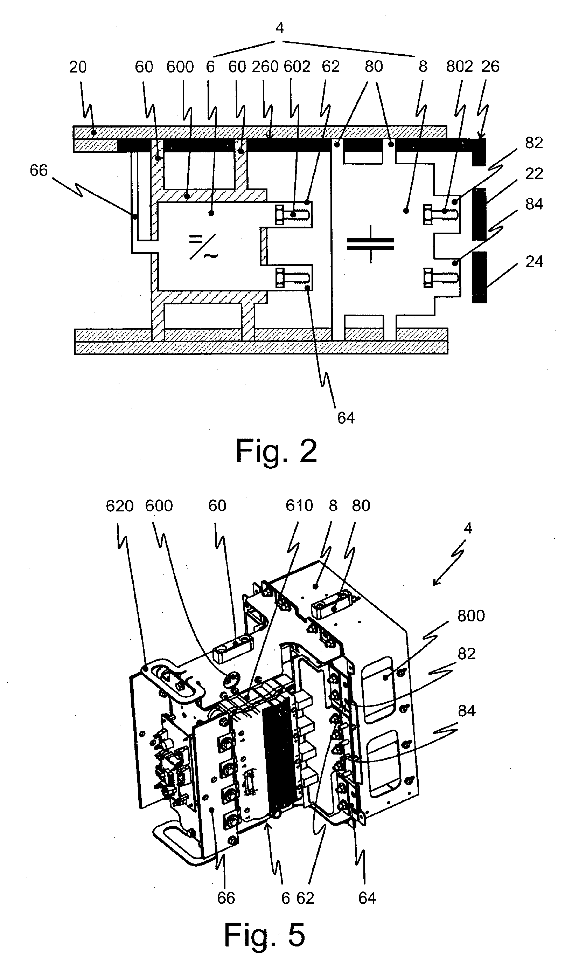

Fig. 2 zeigt die eine ebenso stark schematisierte Detailansicht analog der Ausgestaltung eines Teils der Stromrichteranordnung (1) gemäß Fig. 1 in Seitenansicht aus der Blickrichtung A. Hierbei wird die gestapelte Anordnung der Verbindungseinrichtung (22, 24, 26) des Schaltschranks (2) in seinem rückwärtigen Bereich, des Kondensatormoduls (8) und des Schaltmoduls (6), jeweils voneinander beabstandet dargestellt, ersichtlich.

Die Verbindungseinrichtung (22, 24, 26) weist hier wiederum zwei Gleichspannungsverbindungsseinrichtung (22, 24) und eine Wechselspannungsverbindungsseinrichtung (26) auf, wobei diese einen parallel zum Schienensystem (20), konkret zu oberen der beiden U-förmigen Profile, angeordneten zusätzlichen Abschnitt (260) aufweist. Dieser Abschnitt (260) reicht bis zu einer Wechselspannungskontakteinrichtung (66) des Schaltmoduls (6).

Weiterhin dargestellt sind je Submodul (6, 8) zwei obere und zwei untere Gleitelemente (60, 80), zur Führung des jeweiligen Submoduls oder des daraus gebildeten Hauptmoduls in dem zugeordneten Schienensystem (20) des Schaltschranks (2). Durch diese seitliche Ansicht wird der Vorteil des erfindungsgemäßen modularen Aufbaus der Stromrichteranordnung (1) besonders deutlich. Wesentlich ist hierbei, dass die Verbindungsmittel aller Verbindungen, die der Montage oder Demontage des Schaltmoduls (6) oder des Hauptmoduls (4) von vorne zugänglich sind und, dass keine die Montage oder Demontage behindernden Komponenten in den Bewegungsraum der Submodule (6, 8) hinein reichen.

Fig. 3 bis 7 zeigen detaillierte Ausbildungen einer erfindungsgemäßen Stromrichteranordnung (1) bzw. von deren Komponenten, in verschiedenen Ansichten.

Fig. 3 zeigt hierbei eine Rückansicht, wobei hier speziell die Wechselspannungsverbindungsseinrichtung (26 a/b/c) deutlich erkennbar ist, die hier je Phase aus zwei flächigen Metallkörpern besteht, die jeweils zusätzliche Abschnitte (260) parallel zu den Schienensystemen aufweisen.

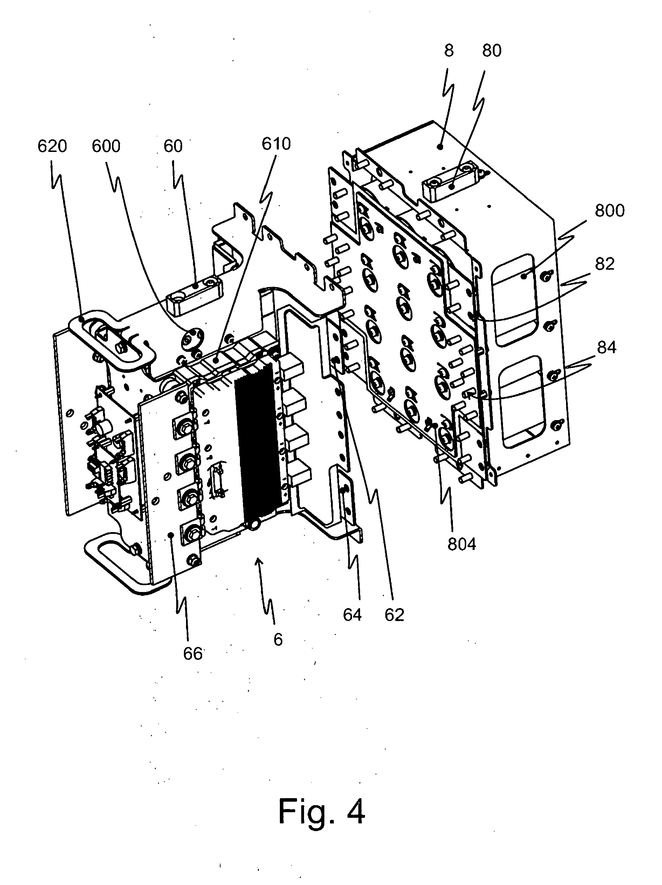

Fig. 4 und 5 zeigt ein Hauptmodul (4) bzw. die das Hauptmodul (4) bildenden Submodule (6, 8) einer erfindungsgemäßen Stromrichteranordnung. Das Kondensatormodul (8) weist hierbei eine Mehrzahl einzelner Kondensatoren (800), sowie eine flächig ausgebildeter Verbindungseinrichtung (804) dieser Kondensatoren (800) für beide Polaritäten der Gleichspannung auf. Diese Verbindungseinrichtung (804) bildet in ihrem seitlichen Außenbereich gleichzeitig die Gleichspannungsverbindungsseinrichtung (82, 84) zum Schaltmodul (6).

An der Oberseite des Kondensatormoduls (8) ist ein Gleitelement (80) dargestellt, das in Verbindung mit dem Schienensystem (20, vgl. Fig.3) der einfachen Montage und Demontage des Kondensatormoduls (8) dient, da durch dessen Führung in dem Schienensystem die Positionierung des Kondensatormoduls nur in einer Dimension, entlang der Schiene, frei ist.

Das Schaltmodul (6) weist eine Kühleinrichtung (600) hier eine Wasserkühleinrichtung auf. Auf dieser Kühleinrichtung (600) sind seitlich jeweils eine Mehrzahl, hier vier, gleichartige Leistungshalbleitermodule (610) angeordnet, die allesamt parallel geschaltet sind und eine Halbbrückenschaltung mit einer Leistung in der Größenordnung von 1 MW ausbilden.

Diesen Leistungshalbleitermodulen (610) ist auf der dem Kondensatormodul (8) zugewandten Seite die Gleichspannungsverbindungsseinrichtung (62, 64) des Schaltmoduls (6) zugeordnet und schaltungsgerecht mit den Gleichspannungsanschlüssen der Leistungshalbleitermodule (610) verbunden. Die Wechselstromanschlüsse der Leistungshalbleitermodule (610) sind auf der dem Kondensatormodul (8) abgewandten Seite angeordnet und mit der Wechselspannungsverbindungsseinrichtung (66) verbunden.

Das Schaltmodul (6) weist fluchtend mit demjenigen des Kondensatormoduls (8) eigene Gleitelemente (60) auf, die zusätzlich mit einem Griff (620) zum verbesserten Handling bei der Montage oder Demontage verbunden sind. Die bei der Beschreibung der Fig. 2 genannten Vorteile sind hier ebenso gegeben.

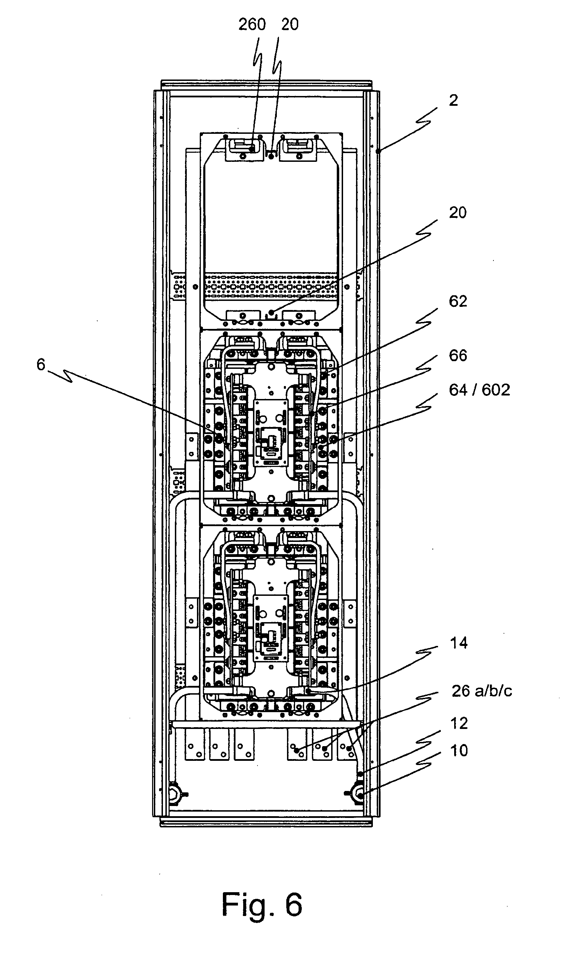

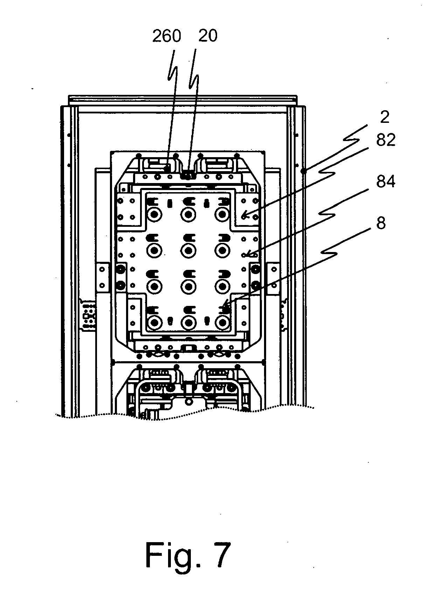

Fig. 6 und 7 zeigen die erfindungsgemäße Stromrichteranordnung (1) von der Frontseite aus. Dargestellt sind entsprechend Fig. 1 in Fig. 6 drei Aufnahmen, wobei die obere nicht bestückt ist, während die beiden anderen jeweils ein Hauptmodul (4) enthalten. Demgegenüber ist in Fig. 7 eine mit einem Kondensatormodul (8) bestückte erste Aufnahme dargestellt.

Im rückwärtigen Bereich des Schaltschranks (2) sind, vgl. Fig. 3, die Wechselspannungsverbindungseinrichtungen (26 a/b/c), je zwei Metallkörper je Phase dargestellt. In der oberen freien Aufnahme des Schaltschranks (2) sind das Schienensystem (20) wie auch die zusätzlichen Abschnitte (260) des Wechselspannungsverbindungsseinrichtung (26) deutlich erkennbar. In diesen Schienensystem (20) sind die Gleiteinrichtungen (60, 80) der Submodule (6, 8) bzw. des hieraus gebildeten Hauptmoduls (4) anordenbar. Parallel zu diesem Schienensystem (20) neben der jeweiligen oberen Schiene sind zwei zusätzliche Abschnitte (260) der Wechselspannungsverbindungseinrichtungen (26) derart angeordnet, dass sie die Montage oder Demontage von Sub- (6, 8) oder Hauptmodul (4) nicht behindern, indem sie nicht in den dafür notwendigen Bewegungsraum hineinreichen.

In den beiden weiteren Aufnahmen sind jeweils Hauptmodule (4) angeordnet, von denen die Leistungshalbleitermodule (610) der Schaltmodule (6) deutlich erkennbar sind. Die Gleichspannungsanschlüsse dieser Leistungshalbleitermodule (610) sind mit der Gleichspannungskontakteinrichtung (62, 64) des Schaltmoduls (6) verbunden, während dieses mit der zugehörigen Gleichspannungskontakteinrichtung (82, 84) des dahinter angeordneten Kondensatormoduls (8) schaltungs- also polaritätsgerecht verbunden ist. Alle zur Montage bzw. Demontage der Hauptmodule (4) notwendigen Verbindungsmittel, wie beispielhaft Schraubverbindungen (602), sind von der Frontseite aus zugänglich.

Weiterhin dargestellt sind in dem Schaltschrank (2) angeordnete Zentralleitungen (10), eine Zu- und eine Ableitung für Kühlflüssigkeiten. Diese Zentralleitungen (10) sind mit in Teilabschnitten flexibel ausgebildeten Kühlwasserzuleitungen (12) zu den jeweiligen Schaltmodulen verbunden. Diese Kühlwasserzuleitungen (12) verbinden die als Wasserkühleinrichtung (600) ausgebildeten Kühleinrichtungen der Schaltmodule (6) und weisen an der Kühleinrichtung (600) einen selbstdichtenden Schnellverschluss (14) zur einfachen Verbindung auf.

Fig. 7 zeigt im Gegensatz zu Fig. 6 ein in der oberen Aufnahme angeordnetes Kondensatormodul (8), wie es bereits unter Fig. 4 und 5 beschrieben ist. Zusätzlich zu den notwendigen elektrischen Verbindungen weist dieses Kondensatormodul (8) neben den Gleitelementen (80) noch eine weitere, vorzugsweise geschraubte, mechanische Verbindung zum Schaltschrank auf. Auch diese mechanische Verbindung ist derart angeordnet, dass sie bei montierten Sub- oder auch Hauptmodul von der Frontseite aus zugänglich ist.

In den dargestellten und beschriebenen erfindungsgemäßen Ausgestaltungen der vorgestellten Stromrichteranordnung (1) ist es möglich einzelne Schaltmodule (6) oder auch Hauptmodule (4) derart in einem Schaltschrank (2) zu montieren, dass eine Demontage dieser Teile im Servicefall einfach ausgeführt werden kann.

## Patentansprüche

1. Modular aufgebaute Stromrichteranordnung (1) mit einer Aufnahmeeinrichtung (2) einer Mehrzahl von jeweilige Hauptmodule (4) ausbildenden Stromrichterbaugruppen , jeweils bestehend aus Submodulen, ihrerseits ausgebildet als jeweils ein Schalt-(6) und ein Kondensatormodul (8),
wobei die Aufnahmeeinrichtung (2) mindestens eine Verbindungseinrichtung (22, 24, 26) zur schaltungsgerechten elektrischen Verbindung der Stromrichterbaugruppen sowie für jede Stromrichterbaugruppe (4) ein Schienensystem (20) zu deren mechanischen Anordnung aufweist,
das Kondensatormodul (8) eine Mehrzahl von Kondensatoren (800), mindestens eine Gleichspannungskontakteinrichtung (82, 84), zur elektrischen Verbindung mit einer Gleichspannungskontakteinrichtung (62, 64) des zugeordneten Schaltmoduls (6) und mit der Verbindungseinrichtung (22, 24, 26) der Aufnahmeeinrichtung (2), sowie Gleitelemente (80) aufweist;
wobei das Schaltmodul (6) eine Kühleinrichtung (600), mindestens ein hierauf angeordnetes Leistungshalbleitermodul (610), eine Wechselspannungs- (66) und eine Gleichspannungskontakteinrichtung (62, 64) sowie Gleitelemente (60) aufweist und
wobei die jeweiligen Gleitelemente (60, 80) der Submodule (6, 8) eines Hauptmoduls (4) in den gleichen zugeordneten Schienen des Schienensystems (20) der Aufnahmeeinrichtung (2) gestapelt derart anordenbar sind, dass die Verbindungseinrichtung (22, 24, 26) der Aufnahmeeinrichtung (2) den ersten Teil des Stapels, das Kondensatormodul (8) den zweiten Teil des Stapels und das Schaltmodul (6) den dritten Teil des Stapels bilden und hierdurch die notwendigen schaltungsgerechten elektrischen Verbindungen der Teile des Stapels ausbildbar sind.

2. Stromrichteranordnung nach Anspruch 1,
wobei die jeweilige Kühleinrichtung (600) eine Wasserkühleinrichtung ist und wobei die Aufnahmeeinrichtung (2) Zentralleitungen (10) aufweist die mit der jeweiligen Kühleinrichtung (600) mittels Schnellverschlüssen (14) verbindbar sind.

3. Stromrichteranordnung nach Anspruch 1,
wobei die Aufnahmeeinrichtung (2) als Schaltschrank ausgebildet ist, an dessen rückwärtiger Seite die Verbindungseinrichtung (22, 24, 26), ausgestaltet als Gleichspannungsverbindungsseinrichtung (22, 24) mit zwei Polaritäten und als Wechselspannungsverbindungseinrichtung (26) mit mindestens einer Phase angeordnet ist.

4. Stromrichteranordnung nach Anspruch 3,
wobei das Schienensystem (20) eines Hauptmoduls (4) mindestens zwei U-Profile zur Führung der Gleitelemente (60, 80) der Submodule (6, 8) aufweist und diese von der rückwärtigen Seite zur Frontseite des Schaltschranks (2) reichen.

5. Stromrichteranordnung nach Anspruch 3,
wobei die Gleichspannungskontakteinrichtung (82, 84) des Kondensatormoduls (8) mit der Gleichspannungsverbindungsseinrichtung (22, 24) des Schaltschranks (2) mittels einer von der Frontseite des Schaltschranks (2) aus erreichbaren Schraubverbindung (802) elektrisch leitend verbunden sind.

6. Stromrichteranordnung nach Anspruch 3,
wobei die jeweiligen Gleichspannungskontakteinrichtungen (62, 64) des Schaltmoduls (6) und des zugeordneten Kondensatormoduls (8) mittels einer von der Frontseite des Schaltschranks (2) aus erreichbaren Schraubverbindung (602) elektrisch leitend verbunden sind.

7. Stromrichteranordnung nach Anspruch 3,
wobei die der jeweiligen Stromrichterbaugruppe zugeordnete mindestens eine Wechselspannungsverbindungseinrichtung (26) einen zusätzlichen parallel zum Schienensystem (20) angeordneten Abschnitt (260) aufweist, der einen Bewegungsraum des Hauptmoduls (4) entlang des Schienensystems (20) nicht beschränkt.

## Claims

1. Modularly constructed converter arrangement (1) comprising a receptacle device (2) for a plurality of converter assemblies forming respective main modules (4), each consisting of submodules, formed for their part as respectively a switching module (6) and a capacitor module (8),
wherein the receptacle device (2) has at least one connection device (22, 24, 26) for the circuit-conforming electrical connection of the converter assemblies and also for each converter assembly (4) a rail system (20) for the mechanical arrangement thereof,
the capacitor module (8) has a plurality of capacitors (800), at least one DC voltage contact device (82, 84), for electrical connection to a DC voltage contact device (62, 64) of the assigned switching module (6) and to the connection device (22, 24, 26) of the receptacle device (2), and also sliding elements (80);
wherein the switching module (6) has a cooling device (600), at least one power semiconductor module (610) arranged thereon, an AC voltage contact device (66) and a DC voltage contact device (62, 64) and also sliding elements (60), and
wherein the respective sliding elements (60, 80) of the submodules (6, 8) of a main module (4) can be arranged in a stacked manner in the same assigned rails of the rail system (20) of the receptacle device (2) in such a way that the connection device (22, 24, 26) of the receptacle device (2) forms the first part of the stack, the capacitor module (8) forms the second part of the stack and the switching module (6) forms the third part of the stack and the necessary circuit-conforming electrical connections of the parts of the stack can thereby be formed.

2. Converter arrangement according to Claim 1,
wherein the respective cooling device (600) is a water cooling device, and wherein the receptacle device (2) has central lines (10) which can be connected to the respective cooling device (600) by means of quick-action closures (14).

3. Converter arrangement according to Claim 1,
wherein the receptacle device (2) is formed as a switchgear cabinet on the rear side of which is arranged the connection device (22, 24, 26) configured as DC voltage connection device (22, 24) having two polarities and as AC voltage connection device (26) having at least one phase.

4. Converter arrangement according to Claim 3,
wherein the rail system (20) of a main module (4) has at least two U-profiles for guiding the sliding elements (60, 80) of the submodules (6, 8) and these extend from the rear side to the front side of the switchgear cabinet (2).

5. Converter arrangement according to Claim 3,
wherein the DC voltage contact device (82, 84) of the capacitor module (8) is electrically conductively connected to the DC voltage connection device (22, 24) of the switchgear cabinet (2) by means of a screw connection (802) that can be reached from the front side of the switchgear cabinet (2).

6. Converter arrangement according to Claim 3,
wherein the respective DC voltage contact devices (62, 64) of the switching module (6) and of the assigned capacitor module (8) are electrically conductively connected by means of a screw connection (602) that can be reached from the front side of the switchgear cabinet (2).

7. Converter arrangement according to Claim 3,
wherein the at least one AC voltage connection device (26) assigned to the respective converter assembly has an additional section (260) arranged parallel to the rail system (20), said section not restricting a movement space of the main module (4) along the rail system (20).

## Revendications

1. Arrangement convertisseur de courant (1) en construction modulaire, comprenant un dispositif d'accueil (2) d'une pluralité de sous-ensembles convertisseurs de courant formant des modules principaux (4) respectifs et respectivement constitués de sous-modules, lesquels sont de leur côté réalisés respectivement sous la forme d'un module de commutation (6) et d'un module condensateur (8),
le dispositif d'accueil (2) présentant au moins un dispositif de liaison (22, 24, 26) destiné à la liaison électrique conforme au circuit des sous-ensembles convertisseurs de courant ainsi que, pour chaque sous-ensemble convertisseur de courant (4), un système de rails (20) destiné à son agencement mécanique,
le module condensateur (8) présentant une pluralité de condensateurs (800), au moins un dispositif de contact de tension continue (82, 84) destiné à la liaison électrique avec un dispositif de contact de tension continue (62, 64) du module de commutation (6) associé et avec le dispositif de liaison (22, 24, 26) du dispositif d'accueil (2), ainsi que des éléments de glissement (80) ;
le module de commutation (6) présentant un dispositif de refroidissement (600), au moins un module à semiconducteur de puissance (610) disposé sur celui-ci, un dispositif de contact de tension alternative (66) et un dispositif de contact de tension continue (62, 64), ainsi que des éléments de glissement (60) et
les éléments de glissement (60, 80) respectifs des sous-modules (6, 8) d'un module principal (4) pouvant être disposés de manière empilée dans les mêmes rails associés du système de rails (20) du dispositif d'accueil (2) de telle sorte que le dispositif de liaison (22, 24, 26) du dispositif d'accueil (2) forme la première partie de la pile, le module condensateur (8) la deuxième partie de la pile et le module de commutation (6) la troisième partie de la pile et les liaisons électriques conformes au circuit nécessaires des parties de la pile peuvent ainsi être formées.

2. Arrangement convertisseur de courant selon la revendication 1, avec lequel le dispositif de refroidissement (600) respectif est un dispositif de refroidissement par eau et avec lequel le dispositif d'accueil (2) présente des conduites centrales (10) qui peuvent être raccordées au dispositif de refroidissement (600) respectif à l'aide de raccords à fermeture rapide (14).

3. Arrangement convertisseur de courant selon la revendication 1, avec lequel le dispositif d'accueil (2) est réalisé sous la forme d'une armoire électrique sur le côté arrière de laquelle est disposé le dispositif de liaison (22, 24, 26), configuré en tant que dispositif de liaison de tension continue (22, 24) avec deux polarités et en tant que dispositif de liaison de tension alternative (26) avec au moins une phase.

4. Arrangement convertisseur de courant selon la revendication 3, avec lequel le système de rails (20) d'un module principal (4) présente au moins deux profilés en U destinés à guider les éléments de glissement (60, 80) des sous-modules (6, 8) et ceux-ci s'étendent du côté arrière au côté avant de l'armoire électrique (2).

5. Arrangement convertisseur de courant selon la revendication 3, avec lequel le dispositif de contact de tension continue (82, 84) du module condensateur (8) est relié de manière électriquement conductrice avec le dispositif de liaison de tension continue (22, 24) de l'armoire électrique (2) au moyen d'une liaison vissée (802) accessible depuis le côté avant de l'armoire électrique (2).

6. Arrangement convertisseur de courant selon la revendication 3, avec lequel les dispositifs de contact de tension continue respectifs (62, 64) du module de commutation (6) et du module condensateur (8) associé sont reliés de manière électriquement conductrice au moyen d'une liaison vissée (602) accessible depuis le côté avant de l'armoire électrique (2).

7. Arrangement convertisseur de courant selon la revendication 3, avec lequel l'au moins un dispositif de liaison de tension alternative (26) associé au sous-ensemble convertisseur de courant respectif présente une portion (260) supplémentaire disposée parallèlement au système de rails (20), laquelle ne limite pas un espace de mouvement du module principal (4) le long du système de rails (20).
